## Europäisches Patentamt

## European Patent Office

## Office européen des brevets

(19)

(11) Veröffentlichungsnummer

**0 019 016**
A2

(12) EUROPÄISCHE PATENTANMELDUNG

(21) Anmeldenummer: 79105291.3

(22) Anmeldetag: 20.12.79

(51) Int. Cl.³: **H 01 L 31/02**
**H 01 L 25/08**

(30) Priorität: 22.12.78 DE 2855553

(43) Veröffentlichungstag der Anmeldung:
26.11.80 Patentblatt 80/24

(84) Benannte Vertragsstaaten:
AT BE CH FR GB IT

(71) Anmelder: Michael, Simon, Dipl.-Ing.
Sanderplatz 14
D-8000 München 60(DE)

(72) Erfinder: Simon, Michael, Dipl. Ing.
Sanderplatz 14
8 München 60(DE)

(72) Erfinder: Gall Sighardt, Dr.
Vogelhardtstrasse 35
8 München 40(DE)

(54) Sonnenenergie-Umwandlungsanlage.

(57) Die Erfindung bezieht sich auf eine Anlage mit einem System das die Solarstrahlung konzentriert und auf elektrizitäterzeugende Sonnenzellen richtet. Vor den Sonnenzellen befindet sich ein selektiver optischer Filter der nur die Solarstrahlen mit bestimmten Wellenlängen auf die Sonnenzellen durchläßt, die von diesen bevorzugt in Elektrizität gewandelt werden können.

Der von dem selektiven optischen Filter nicht durchgelassene Anteil der Strahlung wird reflektiert und weiter auf einen sekundären Absorber konzentriert, der die Restenergie als Wärme hoher Temperatur sammelt und für z.B. industrielle Prozesse zur Verfügung stellt.

Durch die Aufteilung der Strahlung in einen 2. Teil zur Wärmeerzeugung wird auch die Wärmebelastung der Sonnenzellen und ihre Temperatur niedriger gehalten, so daß sich damit ihr elektrischer Wirkungsgrad erhöht.

In der beigefügten Abbildung ist das Funktionsprinzip der Anlage schematisch und perspektivisch dargestellt.

München, den 14. Dezember 1978

## Sonnenenergie-Umwandlungsanlage

Die Erfindung bezieht sich auf eine Sonnenenergie-Umwandlungsanlage mit einem strahlenbündelnden System, wobei die gebündelten Strahlen von Solarzellen und mindestens einem Absorber aufgenommen werden.

Es sind Energie-Umwandlungssysteme mit Solarzellen bekannt,
die mittels Reflektoren oder Linsen konzentrierte Sonnenstrahlung auf die Zellen, beispielsweise Silizium- oder
Germaniumzellen, leiten. Da der Wirkungsgrad der Zellen aber
mit steigender Temperatur abfällt, müssen die Solarzellen
bei hohem Konzentrationsverhältnis gekühlt werden.

Bei einem bekannten System (DE-OS 25 57 296) sind mehrere
strahlenkonzentrierende Spielgel derart angeordnet, daß jeweils der Brennpunkt eines Spiegels auf die Rückseite des
nächsten Spiegels fällt, wo die Solarzellen angebracht sind.

Der Spiegel dient hierbei jeweils als Radiator, um durch thermische Abstrahlung den nicht in elektrische Energie umgesetzten Anteil der Sonnenstrahlung abzuleiten.

Bei der vorhergehend beschriebenen Vorrichtung bleibt die Verlustwärme ungenutzt. Man untersucht jedoch auch die Verlustwärme zu nutzen, so daß die eingefangene Sonnenenergie durch Umwandlung in elektrische bzw. thermische Energie nahezu vollständig genutzt wird.

Ein bekanntes System dieser Art (DE-OS 25 01 907) besteht aus einer behälterförmig ausgestalteten Solarzellen-Baugruppe, in der eine lumineszierende Flüssigkeit enthalten ist. Die Flüssigkeit setzt die von einer Zylinderlinse gebündelte Sonnenstrahlung in eine den Solarzellen angepaßte Strahlung um, die von den Zellen absorbiert wird. Der übrige Anteil der Strahlungsenergie wird in Wärmeenergie umgewandelt und von der gleichzeitig als Wärmeträger dienenden lumineszierenden Flüssigkeit an einen Wärmetauscher geleitet. Bezüglich der Gestaltung ist diese bekannte Vorrichtung recht unflexibel und gebunden, so daß für viele Zwecke eine optimale Orientierung des Systems kaum möglich ist.

Der Erfindung liegt die Aufgabe zugrunde, eine Anlage der eingangs genannten Art zu schaffen, die fertigungstechnisch einfach
herstellbar ist und eine bessere Nutzung der Sonnenenergie gewährleistet.

Die Aufgabe ist erfindungsgemäß dadurch gelöst, daß ein Sekundärspiegel spektral selektiert wird, wobei das von den Solarzellen
wirksam nutzbare Spektrum durchgelassen und mit dem Zellenwirkungsgrad einer Solarzelle in elektrische Energie umgewandelt wird, während der von den Zellen nicht oder nur gering
umsetzbare spektrale Anteil auf einen thermischen Absorber
reflektiert und thermisch von den Solarzellen getrennt in
Wärme umgesetzt wird. Mit dem von den Solarzellen thermisch
getrennten Absorber läßt sich ein höheres Temperaturniveau
erzielen, ohne Einbuße des Zellenwirkungsgrades.

Eine wirkungsvolle und fertigungstechnisch einfache Ausführung
ergibt sich mit einer Anordnung, in der der Sekundärspiegel
im Strahlengang zwischen den Solarzellen und dem strahlenbündelnden System liegt.

Hierbei können das primär strahlenbündelnde System, der
Sekundärspiegel, die Solarzellen und der Absorber in einfacher
Weise als Baugruppe, die im Betrieb der Sonnenbahn nachgeführt
wird, zusammengefaßt werden. Die durch dieses System eingefangene, gebündelte und spektral geteilte Strahlung wird voll
genutzt, indem die vom Sekundärspiegel durchgelassene Strahlung
von den dahinter angeordneten Zellen aufgenommen und mit dem
Zellenwirkungsgrad in elektrische Energie umgewandelt wird,
während die vom Sekundärspiegel reflektierte Strahlung durch
den Absorber in Wärmeenergie umgesetzt wird. Damit läßt sich
eine optimale Nutzung der primärgebündelten Solarenergie
erreichen.

Eine besonders vorteilhafte Ausgestaltung ergibt sich durch
Verwendung eines Spiegels, der die solare Strahlung auf einen
Brennpunkt oder eine Brennlinie bündelt, wobei ein flacher
Sekundärspiegel zwischen dem Primärspiegel und seinem Brennpunkt bzw. seiner Brennlinie den Querschnitt der Rückstrahlung
abdeckend dicht vor den Solarzellen angeordnet ist und die
reflektierende Strahlung auf einen Sekundär-Brennpunkt bzw.
eine Sekundär-Brennlinie konzentriert, worin der Absorber angeordnet ist.

Hierdurch lassen sich alle primär reflektierten Strahlen, und
damit die gesamte auf dem Primärspiegel auftretende Sonnenstrahlung auf die Energie-Umwandlungselemente richten und damit
eine zur Wirkfläche des Primärspiegels proportionale Ausbeute
der Sonnenenergie erreichen. Dabei ist von besonderer Bedeutung, daß der Absorber bei höherem Konzentrationsverhältnis und höherer Temperatur (gegenüber den Solarzellen)
arbeitet, damit höherwertige thermische Energie liefert,
während gleichzeitig eine thermische Entlastung der Solarzellen
durch die Abspaltung der nicht mehr oder nur gering nutzbaren
spektralen Anteile erfolgt.

Die Solarzellen können einfach in einer parallelen Ebene
angeordnet werden. Vorzugsweise können aber im Winkel
zueinander stehende Solarzellen-Strukturen verwendet werden,
um eine möglichst große Solarzellenfläche mit etwa senkrechtem Strahleneinfall bei geringer räumlicher Ausdehnung
zu erhalten, die es erlaubt, den Wirkungsgrad weiter anzuheben.

Besonders vorteilhaft ist es, als Primärspiegel einen Zylinder-
Parabolspiegel mit einem in der Sekundär-Brennlinie angeordneten
Absorberrohr, in dem ein flüssiges oder gasförmiges Wärmeübertragungsmedium geführt wird, zu verwenden.

Es ist auch möglich, daß nicht nur zwei Absorber oder Brennpunkte, sondern durch einen weiteren, tartiären Selektierspiegel ein dritter Absorber oder Brennpunkt für einen dritten
Wellenlängenbereich der eingestrahlten Solarenergie genutzt wird In der Zeichnung sind Ausführungsbeispiele gemäß der Erfindung
schematisch dargestellt.

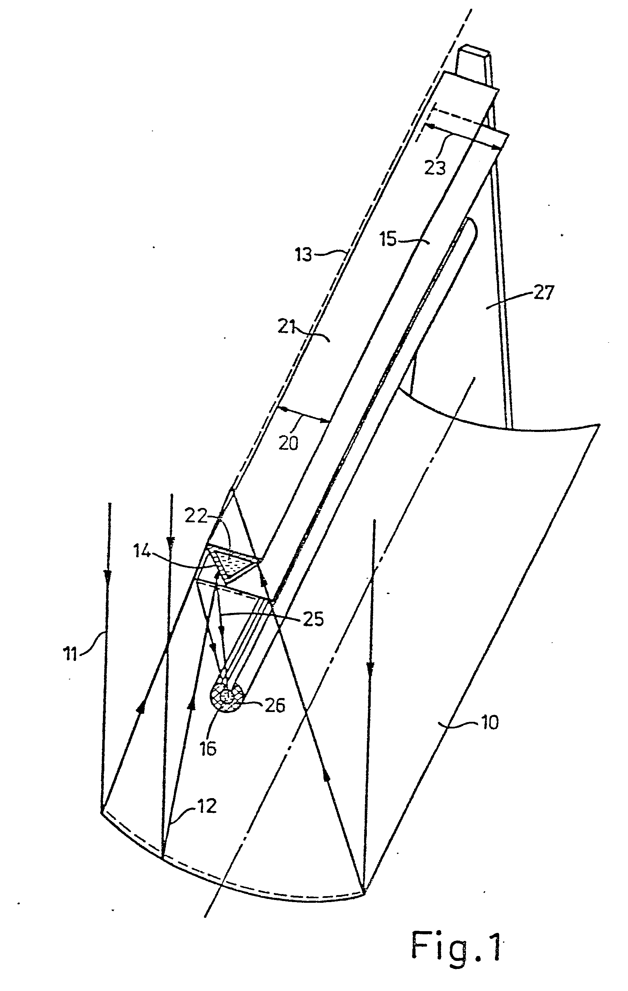

In Fig. 1 ist eine Anlage mit einem Zylinder-Parabolreflektor
10 als Primärspiegel dargestellt. Das auf den Primärspiegel
10 treffende Sonnenstrahlenbündel, dargestellt in den Randstrahlen 11, wird reflektiert und (Randstrahlen 12) auf die
Primär-Brennlinie 13 hin gebündelt. Zwischen Primärspiegel
10 und Brennlinie 13 sind der Reihe nach ein Absorber 16,
ein selektiver Sekundärspiegel 15 und ein Solarzellensystem 14
angeordnet.

Die Bauteile 14, 15 und 16 befinden sich auch im Strahlengang
des einfallenden Lichtes (Randstrahlen 11). Um eine hierdurch
erzeugte Abschattung möglichst gering zu halten, wird die der
Sonne zugekehrte Fläche bzw. die Breite 20 des Zellenbauelementes 14 möglichst klein gehalten. Durch eine schräge
Anordnung der Solarzellen 14 wird somit die Abmessung 20
klein und die Zellenoberfläche jedoch groß gehalten. Die in
Fig. 1 gezeigte Gestaltung des Zellenelementes eignet sich
gleichzeitig zur direkten Zu- und Abführung eines Kühlmittels
mit Hilfe einer Abdeckung 21.

Eine Konvektrons-Kühlung der Solarzellen wird beispielsweise bei Anlagen mit hohem Konzentrationsverhältnis erforderlich sein.

Das Solarzellenelement 14 wird so nahe an der Primär-Brennlinie 13 angeordnet, daß die von der Strahlung zu beaufschlagende Breite 20 gleich oder etwas kleiner dem linearen Querschnitt des reflektierten Bündels 12 entspricht. Dicht unterhalb des Zellenelementes 14 ist dann der Sekundärspiegel 15 mit der Breite 23 des linearen Querschnitts (reflektiertes Bündel) angeordnet. Hierdurch ist gewährleistet, daß die gesamte Reflexionsstrahlung 12 bei geringst möglicher Dimensionierung des Sekundärspiegels 15 vollständig auf diesen auftrifft.

Durch den fokusierenden Primärspiegel 10 kann ein ebener selektiver Sekundärspiegel 15 verwendet werden, der die Strahlen 25 auf eine Sekundär-Brennlinie reflektiert. Im Bereich dieser Sekundär-Brennlinie ist der als Rohr ausgebildete Absorber 16 angeordnet. Das Absorberrohr 16 wandelt Strahlungsenergie in Wärmeenergie um und überträgt sie an einen im Rohr 16 geführten Wärmeträger. Um eine Abstrahlung von Wärme aus dem Absorberrohr 16 zu verhindern, ist das Rohr an der von der Strahlung nicht beaufschlagten Seite mit einem Isoliermaterial 26 umgeben.

- 9 -

Die Einzelelemente 10, 14, 15 und 16 sind über Träger 27 zu einer Baueinheit zusammengefaßt, die einzeln oder zu mehreren neben- und hintereinander an eine Tragstruktur befestigt werden.


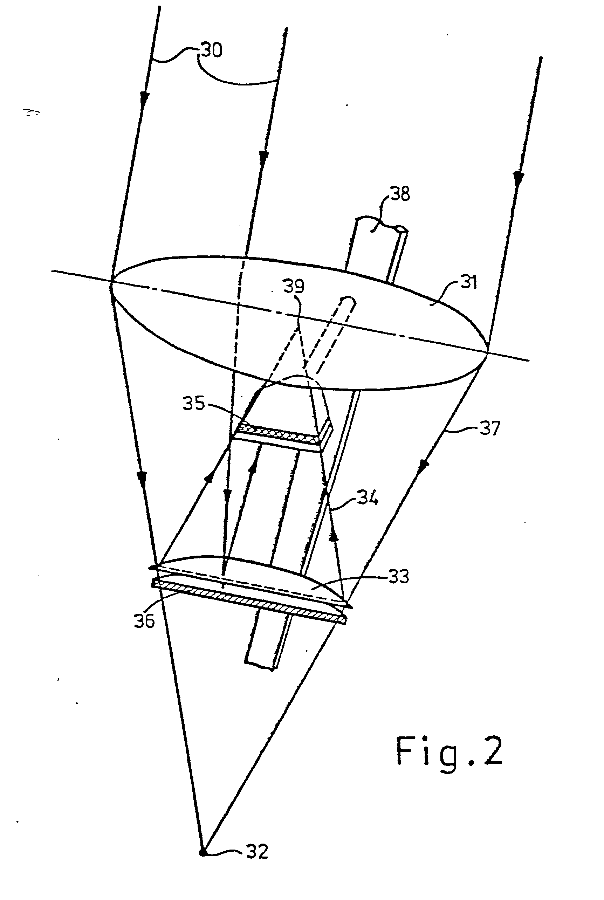

In ähnlicher Weise läßt sich das erfindungsgemäße System für punktförmig konzentrierende Spiegel oder Linsen anwenden, wie z.B. die mit einer Sammellinse ausgestatteten Anordnung in Fig. 2 gezeigt ist. In dieser Ausführung wird das Sonnenlicht 30 vor einer Sammellinse 31 auf einen Brennpunkt 32 fokusiert. Innerhalb der Brennweite ist der spektral selektive Sekundärspiegel 33 angeordnet, der einen Strahlungsanteil 34 auf einen im wesentlichen flach ausgebildeten Wärmetauscher 35 reflektiert, während der andere Anteil durchgelassen und auf Solarzellen 36 gerichtet ist. Wie im vorhergehenden Fall können auch hier die Bauelemente mit Stegen 38 zu einer Einheit zusammengefaßt werden. Diese Ausführung erlaubt eine flexible Dimensionierung des Zellenelementes, wobei zur Verminderung der darauf auftreffenden Strahlungsdichte das Element möglichst mit größerer Wirkfläche ausgelegt und entsprechend näher an die Sammellinse 32 angeordnet wird. Hierbei ist allerdings zu berücksichtigen, daß der sekundäre Brennpunkt 39 zwischen Linse 31 und Brennpunkt 32 zu liegen kommt, um den Wärmeabsorber 35 so klein wie möglich zu halten und trotzdem die gesamte Rückstrahlung

34 aufzunehmen.

- 𝑔 -

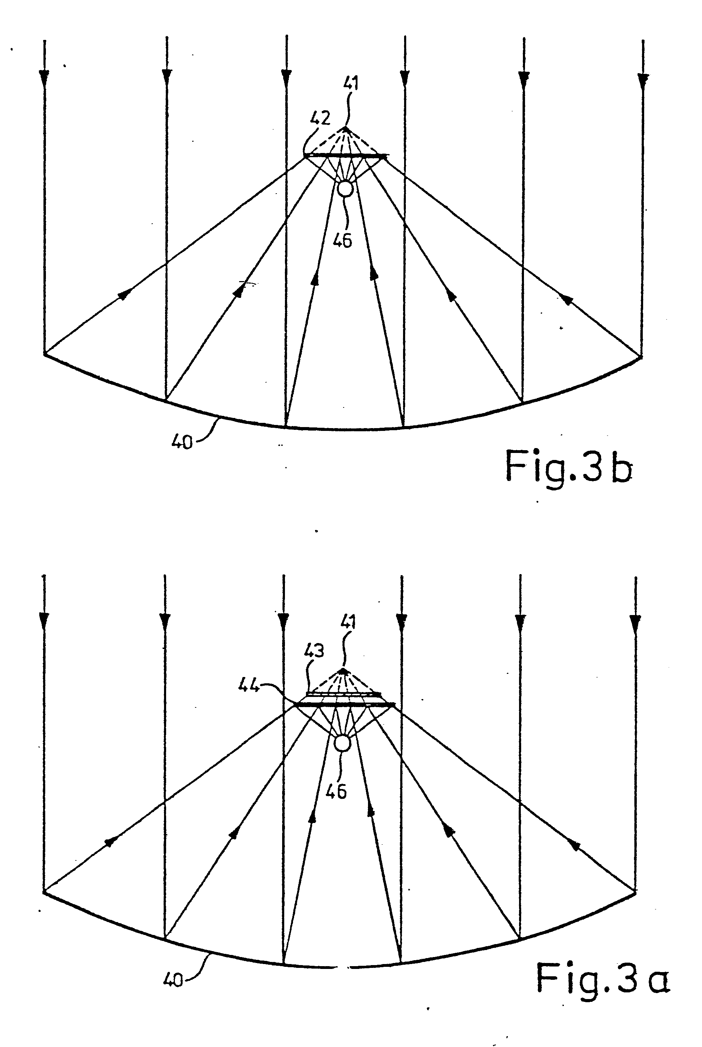

In Fig. 3a und 3b sind Schnitte durch Zylinder- oder Vollparaboloidspiegel 40 gelegt. Die Solarstrahlung wird auf den Primärbrennpunkt 41 hin reflektiert, wobei die spektrale Strahlungsselektion durch einen von den Solarzellen 43 getrennten Sekundärspiegel 44 oder durch entsprechende Präparierung der Solarzellenflächen 42 selbst vorgenommen wird und zu Umsetzungen
in den Zellen 42 bzw. 43 und im Absorber 46 führt.

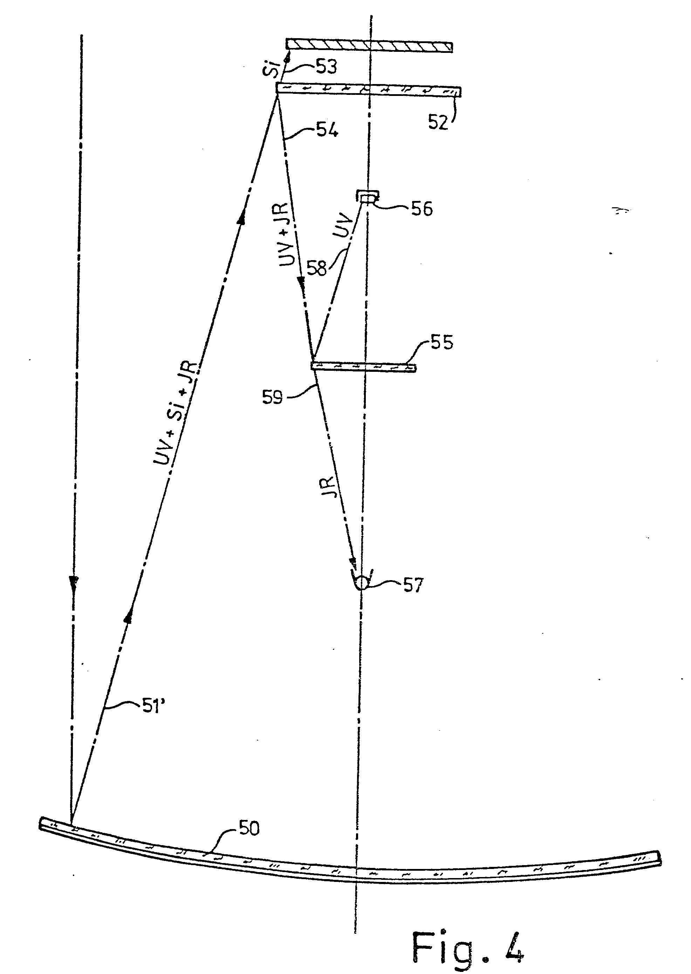

Analog dem Vorhergesagten kann die selektive Auskopplung von
Wellenlängenbereichen zwei oder mehrmals erfolgen, so daß
drei oder mehr verschiedene Absorber oder Brennpunkte genutzt
werden können. In Fig. 4 ist ein Ausführungsbeispiel im Querschnitt hierzu gezeigt, in dem die von einem Primärspiegel 50
reflektierte Strahlung (Randstrahlen 51) auf einen sekundären,
selektiven Spiegel 52 auftrifft. Der von dem Sekundärspiegel 52
durchgelassene Wellenbereich 53 wird in einem Primärabsorber,
beispielsweise einer Silicon-Solarzelle, umgesetzt. Der reflektierende Anteil 54 wird mittels eines tertiären, selektiven
Spiegels 55, beispielsweise eines Kaltlichtspiegels 56, z.B.
einer Al Ga As-Solarzelle, und eines tertiären, thermischen Absorbers 57 empfangen die vom Tertiärspiegel reflektierte 58
bzw. die durchgelassene 59 Strahlung.

Die vorhergenannten Systeme können ferner dahingehend modifiziert werden, daß nach dem primären Konzentrationsspiegel 50
ein sekundärer Kaltlichtspiegel 60 mit einem dahinterliegenden

- 10 -

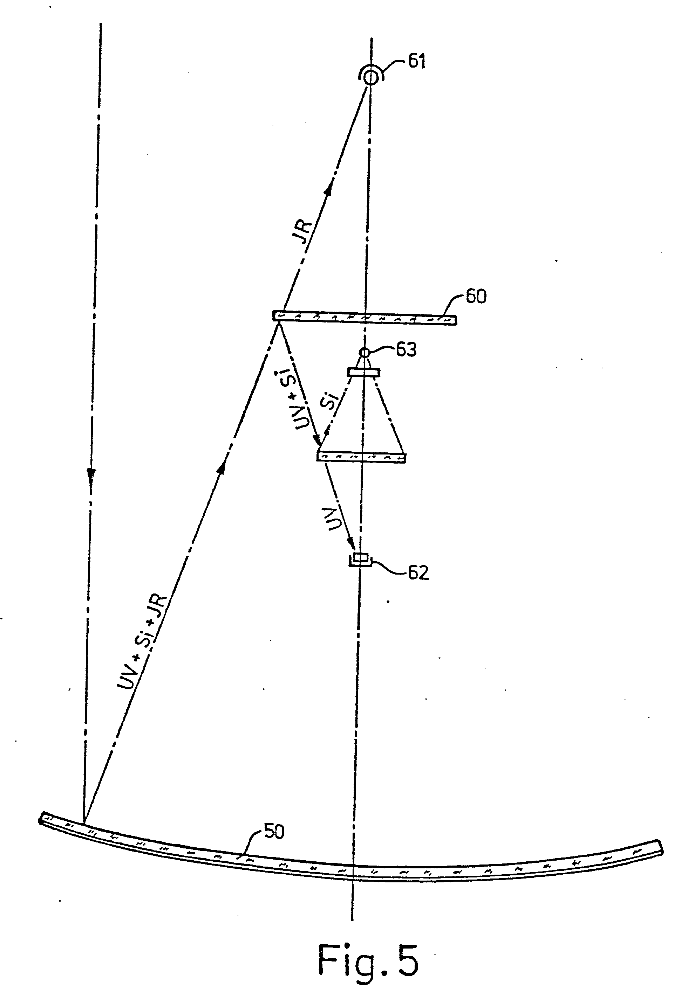

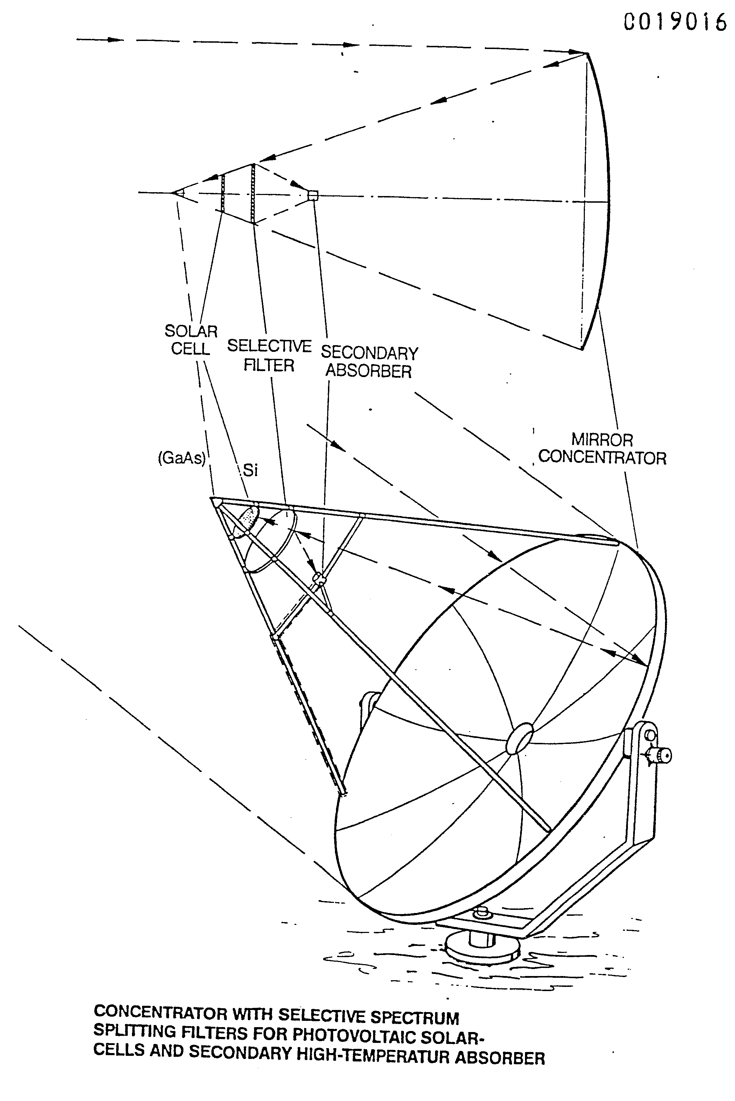

primären thermischen Absorber 61 verwandt wird, während die
reflektierten kurzwelligeren Strahlungsbereiche in einem sekundären 62 und/oder tertiären Absorberbrennpunkt 63 genutzt
werden (Fig. 5).

München, den 14. Dezember 1978

P a t e n t a n s p r ü c h e

1. Sonnenenergie-Umwandlungsanlage mit einem strahlenbündelnden System, wobei die gebündelten Strahlen von Solarzellen und mindestens einem Wärmeabsorber aufgenommen werden, dadurch gekennzeichnet, daß ein Sekundärspiegel (15) vorgesehen ist, durch den die gebündelte Sonnenstrahlung spektral selektiert wird, wobei das von den Solarzellen wirksam nutzbare Spektrum durchgelassen und mit dem Zellenwirkungsgrad einer Solarzelle (14) in elektrische Energie umgewandelt wird, während der von den Zellen nicht oder nur gering umsetzbare spektrale Anteil auf einen thermischen Absorber (16) reflektiert und thermisch von den Solarzellen getrennt in Wärme umgesetzt wird.

2. Anlage nach Anspruch 1, dadurch gekennzeichnet, daß der strahlenselektierende Sekundärspiegel (15) im Strahlengang (12) zwischen dem strahlenbündelnden System (10) und den Solarzellen (14) angeordnet ist.

- 2 -

3.  Anlage nach Anspruch 1 oder 2, dadurch gekennzeichnet, daß der Sekundärspiegel (15) eben ist und eine der Querschnittsgeometrie des Strahlenbündels angepaßte Kontur hat.

4.  Anlage nach Anspruch 1, dadurch gekennzeichnet, daß die Funktion des Sekundärspiegels (15) durch entsprechend wirksame ebene Solarzellenflächen (14) unmittelbar wahrgenommen wird.

5.  Anlage nach einem der vorhergehenden Ansprüche, dadurch gekennzeichnet, daß das strahlenbündelnde System (10) aus einem Zylinder-Parabolspiegel besteht.

6.  Anlage nach einem der Ansprüche 1 bis 4, dadurch gekennzeichnet, daß das strahlenbündelnde System aus ein Vollparabolspiegel besteht.

7.  Anlage nach einem der Ansprüche 1 bis 4, dadurch gekennzeichnet, daß das strahlenbündelnde System aus mindestens einer konvexen Sammellinse (31) oder Fresnellinse besteht.

8.  Anlage nach einem der Ansprüche 1 bis 3, dadurch gekennzeichnet, daß die Solarzellen (14) gewinkelt angeordnet sind.

9. Anlage nach einem der vorhergehenden Ansprüche, dadurch
gekennzeichnet, daß die Absorberwärme unmittelbar in einem
Sorptionskühlkreislauf als Heizwärme genutzt wird, um das
Temperaturniveau der Solarzellen entsprechend herabzusetzen
und damit den temperaturabhängigen Zellenwirkungsgrad anzuheben.

10. Anlage nach einem der vorhergehenden Ansprüche, dadurch
gekennzeichnet, daß ein tertiärer Selektierspiegel (55)
für einen dritten Absorber (56) vorgesehen ist.

11. Anlage nach einem der vorhergehenden Ansprüche, dadurch
gekennzeichnet, daß das von einem selektiven Sekundärspiegel reflektierte Licht in Solarzellen im sichtbaren-
bzw. Ultraviolett-Wellenlängenbereich genutzt wird, während
das Infrarot-Spektrum wie bei einem Kaltlichtspiegel durchgelassen und einem thermischen Absorberbrennpunkt zugeführt wird.

Fig.1

Fig.2

Fig.3b

Fig.3a

Fig. 4

Fig.5

CONCENTRATOR WITH SELECTIVE SPECTRUM
SPLITTING FILTERS FOR PHOTOVOLTAIC SOLAR-
CELLS AND SECONDARY HIGH-TEMPERATUR ABSORBER